# EUROPEAN PATENT SPECIFICATION

(11) **EP 3 553 832 B1**
(45) Date of publication and mention of the grant of the patent: **18.05.2022**
(21) Application number: 17879377.4
(22) Date of filing: 25.09.2017
(51) Int. Cl.: H01L 31/05

(54) **SOLAR CELL MODULE**
SOLARZELLENMODUL
MODULE DE CELLULES SOLAIRES

(30) Priority: 08.12.2016 JP 2016238368
(43) Date of publication of application: 16.10.2019
(73) Proprietor: Kaneka Corporation, Osaka-shi, Osaka 530-8288 (JP)
(72) Inventor: KOIZUMI, Gensuke, Settsu-shi, Osaka 566-0072 (JP); TERASHITA, Toru, Settsu-shi, Osaka 566-0072 (JP)
(74) Representative: V.O.
(86) International application number: PCT/JP2017/034557
(87) International publication number: WO 2018/105202

(56) References cited:
- EP-A1- 2 660 878
- WO-A1-2016/035897
- CN-A- 103 972 317
- JP-A- 2003 086 820
- JP-A- 2006 165 148
- JP-A- 2010 087 011
- JP-A- 2010 093 040
- JP-A- 2013 527 627
- JP-A- 2016 035 097
- US-A1- 2009 266 579
- US-A1- 2011 073 165
- US-A1- 2016 149 065

## Description

### TECHNICAL FIELD

The present invention relates to a solar cell module.

### BACKGROUND ART

Solar cells that include crystalline semiconductor substrates such as a single-crystalline silicon substrate and a polycrystalline silicon substrate have a small area for one substrate, and thus in practical use, a plurality of solar cells are electrically connected and modularized for increasing output. A wiring member composed of a metal foil, etc. is connected to an electrode of a solar cell through solder, a conductive adhesive or the like to electrically connect adjacent solar cells. A solar cell string in which a plurality of solar cells are connected by a wiring member is encapsulated between a light-receiving-surface protection member and a back-surface protection member to obtain a solar cell module.

When viewed from the light-receiving side, a back contact solar cell exhibits a black color because a metal electrode is not provided on a light-receiving surface. In modularization of back contact solar cells, electrodes on the back surfaces of adjacent solar cells are electrically connected to each other through a wiring member.

When a black sheet is used as a back-surface protection member in a solar cell module comprising back contact solar cells, solar cells and a gap therebetween are uniformly colored black when the solar cell module is viewed from the light-receiving surface, so that the visuality is improved. However, a wiring member for connecting adjacent solar cells has metallic luster. Thus, when a solar cell module is installed on a roof or a wall surface of a building, reflected light of sunlight applied to a wiring member is visually recognized, so that the visuality may be impaired.

Patent Document 1 suggests that a portion exposed to the wiring member on the light-receiving side is covered with a colored resin layer to suppress deterioration of the visuality by metallic luster of the wiring member. In Patent Document 2, a shield composed of an insulating tape or the like is positioned between adjacent solar cells to cut off the view of the wiring member from the light-receiving side, so that the visuality of the module is improved.

Patent Document 3 discloses a solar module with interconnectors with improved flexibility, using a conductive fabric of woven or knitted wires between the solar elements, which may be soldered or welded to the solar elements. The document shows an example with back contact solar cells and a stripe of metal cloth wires positioned on the back surface of two solar cells in such way, that it electrically connects the positive contact of one cell to the negative contact of the other one.

Patent Document 4 discloses a solar cell module with back contact solar cells and an interconnector configured to electrically connect adjacent solar cells. The front surface of the interconnector may be processed to have the same color as the back contact solar cell or the back sheet, for example, black or white.

### PRIOR ART DOCUMENTS

### PATENT DOCUMENTS

Patent Document 1: Japanese Patent Laid-open Publication No. 2010-87011
Patent Document 2: National Publication of International Patent Application No. 2008-502149
Patent Document 3:US patent application publication No 2009266579
Patent Document 4: US patent application publication No 2011073165

### SUMMARY OF THE INVENTION

### PROBLEMS TO BE SOLVED BY THE INVENTION

When the wiring member is covered with an insulating resin layer as suggested in Patent Document 1, it is necessary to pattern the resin layer on the wiring member such that the resin layer selectively covers non-connection portion with the electrode of the solar cell, and the connection portion with the electrode of the solar cell is not covered. At the time of connecting the wiring member to the solar cell, it is necessary to perform alignment so that a portion which is not covered with the resin layer is connected to the electrode of the solar cell. Thus, problems occur such as an increase in manufacturing cost of the wiring member, an increase in man-hour for alignment during connection of the wiring member, a reduction in yield of the wiring member or the solar cell module, and the like.

In a configuration in which a shield is disposed between adjacent solar cells as in Patent Document 2, the shield is sandwiched between the solar cell and the wiring member at the end portion of the solar cell. Thus, due to a decrease in contact area between the wiring member and the electrode of the solar cell, bending stress of the wiring member, and the like, the power of the solar cell module may be reduced, and reduction of power is noticeable in a temperature cycle test.

In view of the above-described circumstances, an object of the present invention is to provide a solar cell module which is entirely uniformly colored black and thus exhibits excellent visuality when viewed from a light-receiving surface and which is inhibited from suffering from power reduction caused by a temperature change or the like, and is excellent in durability.

### MEANS FOR SOLVING THE PROBLEMS

A solar cell module of the present invention is defined by the subject-matter of claim 1 and includes a solar cell string in which a plurality of solar cells each having a light-receiving surface and a back surface where the back surfaces of adjacent solar cells are electrically connected through a wiring member. In the solar cell string, a metal electrode disposed on the back surface of the solar cell is connected to a first principal surface of the wiring member by, for example, solder. A light-transmissive light-receiving-surface protection member is disposed on the light-receiving side of the solar cell string, and a back-surface protection member is disposed on the back surface of the solar cell string. The solar cell string is encapsulated with an encapsulant packed between the light-receiving-surface protection member and the back-surface protection member.

The solar cell is a back contact solar cell in which no metal electrode is provided on the light-receiving surface and metal electrodes are disposed only on the back surface. The principal surface on the light-receiving side of the back-surface protection member is black. The wiring member is a braided wire having a flat-shaped cross-section and composed of a plurality of metal element wires, and the first principal surface of the wiring member is connected to the metal electrode of the solar cell. The wiring member has an electroconductive black layer on the entire first principal surface.

The material of the metal element wire of the wiring member is preferably copper or a copper alloy. The electroconductive black layer on the surface of the wiring member is preferably a metal layer containing palladium, and is formed on the surface of the wiring member by, for example, electroless plating.

### EFFECTS OF THE INVENTION

The solar cell module of the present invention is excellent in visuality because it is entirely uniformly colored black when viewed from a light-receiving surface. In addition, since contact resistance between an electrode of a solar cell and a wiring member is small, excellent power characteristics are exhibited. Further, since the wiring member has flexibility, the solar cell module is excellent in temperature cycle durability.

### BRIEF DESCRIPTION OF THE DRAWINGS

FIG. 1 is a schematic sectional view of a solar cell module according to one embodiment.
FIG. 2 is a plan view of a back surface of a solar cell grid.
FIG. 3 is a schematic perspective view of a solar cell string.
FIG. 4 shows a configuration of a sample for evaluation of contact resistance.

### MODE FOR CARRYING OUT THE INVENTION

### [Structural outline of solar cell module]

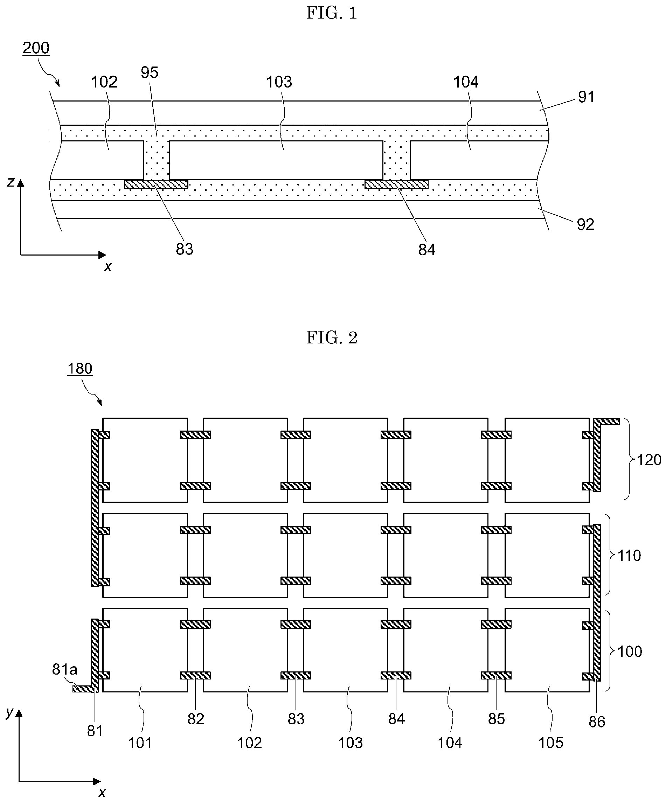

FIG. 1 is a schematic sectional view of a solar cell module (hereinafter referred to as a "module") according to one embodiment. A module 200 shown in FIG. 1 includes a solar cell string in which plurality of solar cells (hereinafter referred to as "cells") 102, 103 and 104 are electrically connected through wiring members 83 and 84.

A light-receiving-surface protection member 91 is disposed on the light-receiving side (the upper side in FIG. 1) of the solar cell string, and a back-surface protection member 92 is disposed on the back side (the lower side in FIG. 1) of the solar cell string. In the module 200, the solar cell string is encapsulated by filling the space between the protection members 91 and 92 with an encapsulant 95.

As the cell, a back contact solar cell (back contact cell) is used. The back contact cell has a p-type semiconductor layer and an n-type semiconductor layer on the back side of a semiconductor substrate of crystalline silicon or the like, and a metal electrode is disposed on each of the p-type semiconductor layer and the n-type semiconductor layer. The metal electrode can be formed by a known method such as printing or plating. For example, an Ag electrode formed by screen printing of an Ag paste, a copper-plated electrode formed by electroplating, or the like is preferred.

The back contact cell does not have a metal electrode on the light-receiving surface of the semiconductor substrate, and photocarriers (holes and electrons) generated in the semiconductor substrate are collected by the metal electrode disposed on the back side of the semiconductor substrate. Since the back contact cell does not have a metal electrode on the light-receiving surface, the entire surface of the cell is uniformly colored black when the cell is viewed from the light-receiving side, so that an excellent visuality is exhibited. Solar cells generally has, though not limited to, a rectangular shape in plan view. The term "rectangular shape" includes a square shape and an oblong shape. The "rectangular shape" is not required to be a perfectly square shape or oblong shape, and for example, the semiconductor substrate may have a semi-square shape (a rectangular shape having rounded corners, or a shape having a notched portion).

The light-receiving surface of the cell preferably has a recessed and projected structure for improving conversion efficiency by increasing the amount of light captured in the semiconductor substrate. The shape of the projection is preferably a quadrangular pyramidal shape. The quadrangular pyramid-shaped projections are formed by, for example, subjecting a surface of the single-crystalline silicon substrate to anisotropic etching treatment. The height of the projection on the light-receiving surface of the cell is, for example, about 0.5 to 10 µm, preferably about 1 to 5 µm. The back surface of the cell may also have a recessed and projected structure.

FIG. 2 is plan view of a back surface of a solar cell grid in which a plurality of back contact cells are arranged in a grid shape. In a solar cell grid 180, solar cell strings 100, 110, and 120 in which a plurality of cells are connected along a first direction (x direction) are arranged side by side along a second direction (y direction) orthogonal to the first direction.

The solar cell string 100 includes a plurality of cells 101 to 105 arranged in a first direction. Electrodes disposed on the back side of cells are electrically connected through wiring members 82 to 85 to form a solar cell string. A plurality of cells is connected in series by connecting the p-side electrode of one of two adjacent cells to the n-side electrode of the other cell through the wiring member. The cells can also be connected in parallel by connecting n-side electrodes or p-side electrodes of adjacent cells.

In the solar cell string 100, the wiring member 81 arranged at one end portion in the first direction includes a lead wire 81a which can be connected to an external circuit. The wiring member 86 arranged at the other end portion in the first direction is connected to the solar cell string 110 adjacent in the second direction.

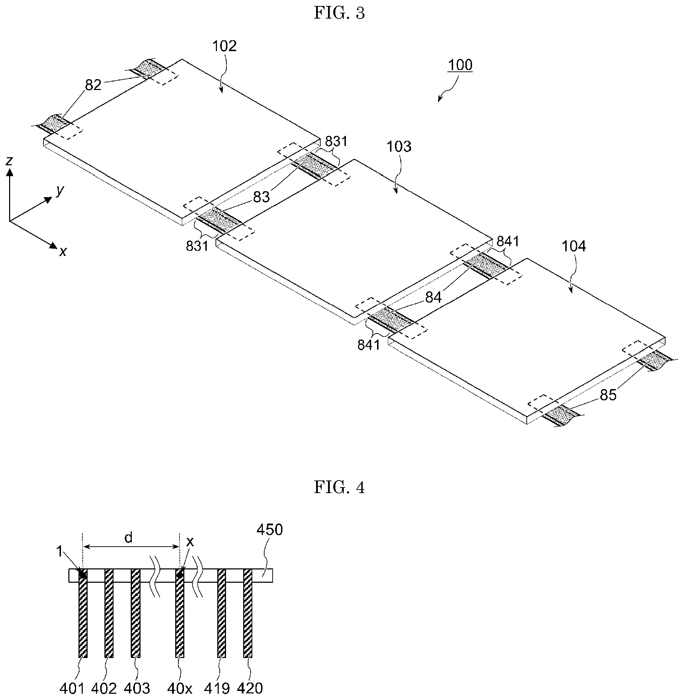

FIG. 3 is a schematic perspective view of the solar cell string 100. In FIG. 3, adjacent cells are connected by two wiring members. The number of wiring members arranged between adjacent cells is appropriately set according to the shape of the electrode pattern of the cell or the like.

In a solar cell module, a portion 831, 841 of a wiring member 83, 84 positioned in a gap between adjacent solar cells is exposed to the light-receiving side, and thus is visible from the outside. As described in detail below, when a wiring member which is black on at least the light-receiving side is used, metal reflection of the wiring member is reduced, and the visual impression between the exposed portion of the wiring member and the cell is unified, so that the visuality of the solar cell module is improved.

### [Wiring member]

The wiring member has a first principal surface, a second principal surface and lateral surfaces. The wiring member is a braided wire having a flat-shaped cross-section and composed of a plurality of metal element wires, and has an electroconductive black layer disposed on the entire first principal surface. In the solar cell string, the wiring member is arranged in such a manner that the first principal surface is on the light-receiving side, and the first principal surface of the wiring member is connected to the back electrode of the cell.

The width of the wiring member is, for example, about 1 mm to 5 mm, and the thickness of the wiring member is, for example, about 50 µm to 500 µm. The diameter of the metal element wire forming the braided wire is, for example, about 10 to 200 µm. The number of metal element wires forming the braided wire is about 10 to 500.

In the back contact cell, the back surfaces of adjacent cells are connected to each other by a wiring member, and therefore shadowing loss does not cause a problem even when the wiring member has a large width (area). When the wiring member has a flat shape, and hence a large width, the contact area between the cell and the wiring member can be increased to reduce contact resistance. In addition, by increasing the contact area between the cell and the wiring member, bonding reliability between the cell and the wiring member is improved, leading to improvement of the durability of the solar cell module.

When the contact area between a plate-shaped wiring member to be used for a general module and the cell increases, a connection failure such as peeling of the wiring member easily occurs due to a difference in linear expansion coefficient between the wiring member and the cell which is caused by a temperature change. On the other hand, a braided wire composed of a plurality of element wires is flexible and stretchable, so that stress caused by a difference in linear expansion due to a temperature change can be absorbed and scattered by the wiring member. Thus, even when the contact area between the cell and the wiring member is increased, high bonding reliability can be maintained.

The braided wire having a flat-shaped cross-section may be formed by knitting a plurality of metal element wires in such a manner as to form a flat shape, or a braided wire obtained by knitting a plurality of element wires into a cylindrical shape may be made to have a flat-shaped cross-section by rolling processing. Examples of the method for knitting metal element wires include plain knitting, single braiding, double braiding, triple braiding, Denbigh knitting, cord knitting, atlas knitting, chain knitting, crochet knitting, fourth-carrier braiding, six-carrier braiding, eight-carrier braiding, wickerwork, triaxial weaving, three-thread braiding, right knotting, left knotting, warp knotting, weft knotting, oblique knitting, rubber knitting, moss knitting, stockinette knitting and garter knitting.

The metal material forming the metal element wire is not particularly limited as long as it is electroconductive. Preferably, the material of the wiring member has a low resistivity for reducing an electrical loss caused by resistance of the wiring member. In particular, copper or a copper alloy containing copper as a main component is preferable because the material is inexpensive.

### (Electroconductive black layer)

The wiring member has an electroconductive black layer at least on the entire first principal surface. When the first principal surface is provided with the electroconductive black layer, light reflection at portions 831 and 841 positioned in gaps between cells and exposed to the light-receiving surface is reduced. Thus, when the module is viewed from the light-receiving side, the colors of the exposed portion of the wiring member and the cell are unified.

From the viewpoint of entirely uniformly coloring the module black, the visible light reflectance of the first principal surface of the wiring member is preferably as small as the reflectance of the light-receiving surface of the cell, and is preferably 10% or less. By forming the black layer described in this specification, a desired visible light reflectance can be attained. On the other hand, since the black layer is composed of an electroconductive material containing a metal, it is difficult to completely eliminate surface reflection.

Since the surface of the braided wire composed of a plurality of metal element wires has irregularities caused by the shape of the metal element wires (generally a circular cross section), light is irregularly reflected at the surface of the wiring member. Thus, light reflected at the surface of the wiring member is visible as hazy scattered light to the viewer on the light-receiving side, and reflected light with metallic luster is hardly visible. Therefore, even when light reflection at the wiring member cannot be completely inhibited, deterioration of the visuality, which is caused by reflected light from the wiring member hardly occurs. When the light-receiving surface of the cell has recessed and projected structure, reflected light at the light-receiving surface of the cell is closely similar in visual impression to reflected light at the first principal surface of the wiring member including a braided wire, and therefore reflected light from the wiring member is inconspicuous, so that the visuality of the module is improved.

On the first principal surface of the wiring members 83 and 84, the electroconductive black layer is formed on the first principal surface in not only the exposed portions 831 and 841 between adjacent cells but also the connection portion to the cell. Since the black layer for anti-reflection has electroconductivity, contact resistance between the electrode of the cell and the wiring member is small, so that the power generation loss in the module can be reduced. Since the electroconductive black layer is formed on the entire first principal surface of the wiring member, precise alignment is not required at the time of connecting the cell to the wiring member. Thus, the productivity and the yield of the solar cell module can be improved.

The electroconductive black layer may be formed on the lateral surface and the second principal surface of the wiring member as in the case of the first principal surface. In a portion which is not exposed to the surface of the wiring member, there may be a non-blackening-treated region where the electroconductive black layer is not provided.

A braided wire having an electroconductive black layer can be obtained by, for example, applying electroconductive-blackening-treatment to a braided wire obtained by knitting metal element wires. A braided wire may be obtained by knitting metal element wires subjected to electroconductive-blackening-treatment. For formation of the electroconductive black layer, for example, a dry process such as a sputtering method, a CVD method or a vacuum vapor deposition method; or a wet process such as application of a metal paste material or electroplating or electroless plating (autocatalysis plating or displacement plating) is applicable.

Examples of the material of the electroconductive black layer formed on the surface of the wiring member include alloys of copper and nickel, chromium, zinc, palladium or the like, metallic palladium or palladium alloys, metal oxides, and metals in which a black material such as carbon nanotubes or carbon is dispersed. In particular, it is preferable that a metal layer containing palladium is formed as the electroconductive black layer because it is excellent in electroconductivity and excellent in adhesion to a metal material such as copper, and has high wettability to solder.

The method for forming a metal layer containing palladium on a wiring member (or on a metal element wires constituting the wiring member) is preferably electroless plating. As an electroless plating solution, for example, an aqueous solution containing a palladium salt, a halide ion, and a nitrogen-containing compound is used. The electroless plating solution is preferably an acidic aqueous solution having a pH of about 0 to 5.

Examples of the palladium salt include palladium chloride, palladium sulfate, palladium oxide, palladium iodide, palladium bromide, palladium nitrate, palladium acetate, tetraamine palladium chloride, dinitrodiamine palladium and dichlorodiethylenediamine palladium. The concentration of palladium in the electroless plating solution is preferably about 0.001 to 5 g/L.

Examples of the halide ion include a chloride ion, a bromide ion and an iodide ion, with a chloride ion being preferable. Examples of the halide ion source for adding a halide ion in the electroless plating solution include halogenated hydroacids such as hydrochloric acid, hydrobromic acid and hydroiodic acid; alkali metal salts such as sodium chloride and potassium bromide; alkaline earth metal salts such as magnesium chloride and calcium iodide; and ammonium chloride and ammonium bromide. The concentration of halide ions in the electroless plating solution is preferably about 1 to 300 g/L.

The nitrogen-containing compound is preferably a polyamine such as an alkylene diamine, polyalkylene polyamine, polyamide polyamine or a crosslinked product of polyamide polyamine. The content of the nitrogen-containing compound in the electroless plating solution is preferably about 0.01 to 200 g/L.

An electroconductive black layer (electroless palladium plated layer) containing palladium is formed by bringing the electroless plating solution into contact with an object for blackening-treatment (wiring member or metal element wire). For example, an object for blackening-treatment may be immersed in the electroless plating solution to bring the electroless plating solution into contact with the object for blackening-treatment. The electroless plating solution may be sprayed to the surface of the object for blackening-treatment.

When a braided wire obtained by knitting metal element wires is immersed in an electroless plating solution, a wiring member is obtained in which an electroconductive black layer is formed on the entire first principal surface, lateral surfaces and second principal surface, *i.e*. the entire exposed portion to the surfaces of metal element wires. When the electroless plating solution sufficiently permeates the inside of the braided wire, the electroconductive black layer is also formed on the portion which is not exposed to the surface of the wiring member of the metal element wire.

On the other hand, when the knitting density of the braided wire is high, or the wettability of the metal element wire to the electroless plating solution is low, the electroless plating solution hardly penetrates the inside. In this case, the portion which is not exposed to the braided wire surface of metal element wires is a non-blackening-treated region on which no electroconductive black layer is formed. For the purpose of uniformly coloring the entire surface of the solar cell module black, it suffices that a black layer is formed on a region visible from outside the wiring member (first principal surfaces of exposed portions 831 and 841). Therefore, the portion which is not exposed to the surface of the wiring member of the metal element wires may be either a blackening-treated region or a non-blackening-treated region.

The treatment temperature in electroless plating is, for example, preferably about 10 to 60°C, more preferably about 20 to 50°C. The treatment time is, for example, preferably about 10 seconds to 10 minutes.

Before electroconductive-blackening-treatment is performed by electroless plating, degreasing treatment, acid treatment or the like may be performed for the purpose of removing contaminants on the surface and oxide films on the surface of an object for plating treatment as necessary. The plated material after electroless plating may be rinsed with water and dried.

### [Formation of solar cell module]

In preparation of a module, first a back contact cell and wiring member including a braided wire subjected to blackening-treatment are prepared, and adjacent cells are connected to each other through the wiring member to prepare a solar cell string. A back electrode of the cell is connected to a first principal surface of the wiring member with an electroconductive connection material such as an electroconductive film or an electroconductive paste interposed therebetween.

When solder is used as an electroconductive connection material, solder may be welded onto the first principal surface of the wiring member or the electrode of the cell in advance. When solder is welded onto the first principal surface of the wiring member in advance, metallic luster of the solder is visible from the light-receiving surface of the module, leading to deterioration of the visuality if the solder is deposited on exposed portions 831 and 841 between adjacent cells.

When solder is welded onto the first principal surface of the wiring member in advance, it is necessary that a region of solder welded onto the wiring member be adjusted so as to prevent protrusion of solder to a visible region, and the wiring member and the cell be precisely aligned during solder connection. On the other hand, a method in which solder is disposed on the electrode of the cell, and the wiring member is connected onto the solder does not require precise alignment for preventing protrusion of solder to a portion in which the wiring member is exposed between cells. Thus, it is preferable that welded solder, a solder paste, or the like is disposed on the electrode of the cell, and the electrode is connected to the wiring member.

When the cell is connected to the wiring member with solder, a solder connection pad may be disposed in a portion of the peripheral edge in the cell surface where finger electrodes are gathered. In a wiring member including a braided wire of a plurality of metal element wires, molten solder is easily retained in a space between metal element wires due to a capillary phenomenon. Thus, spreading of solder is suppressed, so that protrusion of solder to the exposed portion of the wiring member between cells hardly occurs. Since solder hardly spreads, the area of the solder connection pad may be reduced.

A wiring member which is used for a general module and composed of a plate-shaped metal member is rigid, so that it may be difficult to align the wiring member and the solder connection pad when the area of the solder connection pad is reduced. On the other hand, a braided wire composed of a plurality of element wires is flexible and stretchable, so that even when positional deviation occurs between adjacent cells, by bending the wiring member, alignment of the wiring member on the solder connection pad can be carried out.

The wiring member including a braided wire is flexible and stretchable, and therefore can be adapted to alignment in a string connection direction (x direction). The wiring member including a braided wire can be bent in cell thickness direction (z direction), so that stress in the thickness direction can be scattered, and even when the cell is warped, defects such as breakage at the time of handling a string after connection of a plurality of cells can be suppressed.

The solar cell string with a plurality of cells connected by the wiring member is sandwiched between a light-receiving-surface protection member 91 and a back-surface protection member 92 with an encapsulant 95 interposed between each of the protection members and the solar cell string, thereby forming the solar cell module. Preferably, a laminate in which the light-receiving-side encapsulant, the solar cell string, the back-side encapsulant and the back-surface protection member are mounted in this order on the light-receiving-surface protection member is heated at predetermined conditions to cure the encapsulant. Before encapsulation, a plurality of solar cell strings may be connected to form a solar cell grid as shown in FIG. 2.

Preferably, a transparent resin such as a polyethylene-based resin composition mainly composed of an olefin-based elastomer, polypropylene, an ethylene/α-olefin copolymer, an ethylene/vinyl acetate copolymer (EVA), an ethylene/vinyl acetate/triallyl isocyanurate (EVAT), polyvinyl butyrate (PVB), silicon, urethane, acrylic or epoxy is used as the encapsulant 95. Materials of the encapsulants on the light-receiving side and the back side may be the same or different.

For the light-receiving-surface protection member 91, which is light-transmissive, glass, transparent plastic or the like is used. As the back-surface protection member 92, a black sheet having a black-color principal surface on the light-receiving side is used. By using a black sheet as the back-surface protection member, not only cells but also both the wiring member and the back-surface protection member exposed between adjacent cells are uniformly colored black. Therefore, a module which is entirely uniformly colored black, and has an excellent visuality can be obtained.

As the black sheet, for example, a sheet including a black resin layer is used. The black resin layer has visible light-absorbency, and mainly absorbs visible light having a wavelength of 800 nm or less. The visible light transmittance of the black resin layer is preferably 10% or less. As a black resin layer, a resin composition containing a thermoplastic resin such as a polyolefin-based resin, a polyester-based resin, an acryl-based resin, a fluororesin or an ethylene-vinyl acetate resin and a colorant such as a pigment or a dye is preferably used.

The black sheet to be used as the back-surface protection member 92 may have infrared ray reflectivity while absorbing visible light. By using the back-surface protection member having infrared ray reflectivity, infrared rays contained in light passing through gaps between adjacent cells and light transmitted through the cells can be reflected to the light-receiving side, and used for power generation. Examples of the black sheet having infrared ray reflectivity include those obtained by stacking a black resin layer and infrared ray reflecting layer, and those containing a pigment having infrared ray reflectivity in a black resin layer. As the infrared reflection layer, a resin layer composed of a resin composition containing a white pigment having infrared ray reflectivity, such as titanium oxide, a metal foil having infrared ray reflectivity (e.g., aluminum or silver), or the like is used.

By using a wiring member including a braided wire as described above, the allowable tolerance of the patterning accuracy and alignment accuracy of electrodes of the cell can be increased, and breakage during handling can be suppressed, so that the module production efficiency and yield can be improved. As described above, in the completed module, stress caused by a difference in linear expansion coefficient due to a temperature change can be absorbed and scattered by the wiring member including a braided wire. Thus, a module is obtained which hardly suffers from a connection failure of a wiring member due to a dimension change, etc. even when subjected to a temperature cycle test, and is excellent in durability.

### EXAMPLES

A braided wire (width: about 2 mm, thickness: about 200 µm) having a flat-shaped cross-section and obtained by knitting total 64 copper wires, where four element wires each having a diameter of about 60 µm and composed of copper were used as a unit, was subjected to blackening-treatment, and evaluated.

### [Solder wettability]

As Example 1, the above-described braided wire was immersed in an electroless palladium plating solution containing 0.5 g/L of palladium ("OPC Black Copper" manufactured by Okuno Chemical Industries Co., Ltd.), so that electroless plating was performed at room temperature to obtain a braided wire having an electroconductive black layer on the entire surface. On element wires inside the braided wire, an electroconductive black layer was not formed, and copper was exposed. In the obtained braided wire, the entire surface was black, and favorable solder wettability similar to that of the braided wire before blackening-treatment was exhibited.

For Example 2 with the braided wire subjected to black chromium treatment, Example 3 with the braided wire subjected to black nickel treatment and Example 4 with the braided wire subjected to black oxide treatment by strong alkali boiling (formation of fine irregular films of copper oxide), evaluation was performed in the same manner as in Example 1. In each of Examples 2 to 4, the entire surface of the wiring member was black, but solder wetting did not occur.

### [Contact resistance]

As schematically shown in FIG. 4, twenty wiring members 401 to 420 were solder-connected at equal intervals in a length direction of a 3 mm-wide belt-shaped copper-plated film 450 to prepare a sample for evaluation of contact resistance. One terminal of a two-terminal resistance meter was brought into contact with a contact point 1 between the wiring member 401 and the copper-plated film 450, and the other terminal was brought into contact with a contact point x between another wiring member and the copper-plated film to measure the resistance between the two points. The resistance was measured while the position at which the other terminal was brought into contact with the wiring member was sequentially changed to positions on the wiring members 402 to 420, the distance d between the terminals and the resistance were plotted, and linear approximation was performed by the least squares method. The contact resistance Rc was calculated from the resistance value 2Rc obtained by extrapolating the obtained approximate line to d = 0.

The contact resistance when a 1.5 mm-wide plate-shaped copper foil was used as a wiring member was 2.3 times the contact resistance when a braided wire which was not subjected to blackening-treatment was used as a wiring member. On the other hand, when the braided wire of Example 1, which was subjected to the blackening-treatment, was used as a wiring member, the contact resistance was 1.1 times that of a braided wire which was not subjected to blackening-treatment. There was no significant change in contact resistance before and after the blackening-treatment. The results reveal that a wiring member composed of a braided wire has lower contact resistance with an electrode material in solder connection as compared to a plate-shaped wiring member, and even in the case of a braided wire subjected to blackening-treatment with palladium, the property is maintained.

From the results above, it can be understood that by using a wiring member in which an electroconductive black layer containing palladium is applied to the surface of a braided wire composed of a plurality of metal element wires, the visual impression of the cell and the wiring member as viewed from the light-receiving side is unified to improve the visuality, and a solar cell module which has smaller contact resistance in solder connection, and is excellent in durability is obtained.

### DESCRIPTION OF REFERENCE SIGNS

- 101 to 105: solar cell (cell)
- 81 to 86: wiring member
- 100, 110, 120: solar cell string
- 91: light-receiving-surface protection member
- 92: back-surface protection member
- 95: encapsulant
- 200: solar cell module

## Claims

1. A solar cell module (200) comprising:
a solar cell string (100, 110, 120) in which a plurality of solar cells (102, 103, 104) each having a light-receiving surface and a back surface wherein the back surfaces of adjacent solar cells are electrically connected through a wiring member (83, 84);
a light-receiving-surface protection member (91) which is light-transmissive and is disposed on a light-receiving side of the solar cell string (100, 110, 120);
a back-surface protection member (92) disposed on a back side of the solar cell string; and
an encapsulant (95) arranged between the light-receiving-surface protection member (91) and the back-surface protection member (92) to encapsulate the solar cell string (100, 110, 120), wherein
the solar cells (102, 103, 104) have
no metal electrode on the light-receiving surface, and have a metal electrode only on the back surface,
a principal surface on a light-receiving side of the back-surface protection member (92) is black,
the wiring member (83, 84) is a braided wire having a flat-shaped cross-section and composed of a plurality of metal element wires, and a first principal surface of the wiring member (83, 84) is connected to the metal electrode of a solar cell (102, 103, 104), and
**characterized in that**
the wiring member (83, 84) has an electroconductive black layer on the entire first principal surface.

2. The solar cell module according to claim 1, wherein the electroconductive black layer is a metal layer containing palladium.

3. The solar cell module according to claim 1 or 2, wherein the metal element wire of the wiring member (83, 84) consists of copper or copper alloy.

4. The solar cell module according to any one of claims 1 to 3, wherein the electroconductive black layer is an electroless plating layer formed on a surface of the metal element wire.

5. The solar cell module according to any one of claims 1 to 4, wherein a visible light reflectance of the first principal surface of the wiring member is 10% or less.

6. The solar cell module according to any one of claims 1 to 5, wherein in a portion which is not exposed to a surface of the wiring member (83, 84), the metal element wire that constitutes the wiring member has a non-blackening-treated region on which no electroconductive black layer is formed.

7. The solar cell module according to any one of claims 1 to 6, wherein the metal electrode on the back surface of the solar cell and the first principal surface of the wiring member are connected with solder.

## Patentansprüche

1. Solarzellenmodul (200), das umfasst:
eine Solarzellenstring (100, 110, 120), in dem mehrere Solarzellen (102, 103, 104) jeweils eine Lichtempfangsfläche und eine Rückfläche aufweisen, wobei die Rückflächen benachbarter Solarzellen durch ein Verdrahtungselement (83, 84) elektrisch verbunden sind;
ein Lichtempfangsflächen-Schutzelement (91), das lichtdurchlässig ist und auf einer Lichtempfangsseite des Solarzellenstrings (100, 110, 120) angeordnet ist; ein Rückflächen-Schutzelement (92), das auf einer Rückseite des Solarzellenstrings angeordnet ist; und
ein Verkapselungsmaterial (95), das zwischen dem Lichtempfangsflächen-Schutzelement (91) und dem Rückflächen-Schutzelement (92) angeordnet ist, um den Solarzellenstring(100, 110, 120) zu verkapseln,
wobei
die Solarzellen (102, 103, 104) keine Metallelektrode auf der Lichtempfangsfläche und eine Metallelektrode nur auf der Rückfläche aufweisen,
eine Hauptoberfläche auf einer Lichtempfangsseite des Rückflächen-Schutzelements (92) schwarz ist,
das Verdrahtungselement (83, 84) ein geflochtener Draht ist, der einen flachförmigen Querschnitt aufweist und aus mehreren Metallelementdrähten zusammengesetzt ist, und eine erste Hauptoberfläche des Verdrahtungselements (83, 84) mit der Metallelektrode einer Solarzelle (102, 103, 104) verbunden ist, und
**dadurch gekennzeichnet, dass**
das Verdrahtungselement (83, 84) eine elektrisch leitende schwarze Schicht auf der gesamten ersten Hauptoberfläche aufweist.

2. Solarzellenmodul nach Anspruch 1, wobei die elektrisch leitende schwarze Schicht eine Metallschicht ist, die Palladium enthält.

3. Solarzellenmodul nach Anspruch 1 oder 2, wobei der Metallelementdraht des Verdrahtungselements (83, 84) aus Kupfer oder einer Kupferlegierung besteht.

4. Solarzellenmodul nach einem der Ansprüche 1 bis 3, wobei die elektrisch leitende schwarze Schicht eine stromlose Plattierungsschicht ist, die auf einer Oberfläche des Metallelementdrahtes ausgebildet ist.

5. Solarzellenmodul nach einem der Ansprüche 1 bis 4, wobei der Reflexionsgrad des sichtbaren Lichts der ersten Hauptoberfläche des Verdrahtungselements 10 % oder weniger beträgt.

6. Solarzellenmodul nach einem der Ansprüche 1 bis 5, wobei der Metallelementdraht, der das Verdrahtungselement bildet, in einem Abschnitt, der nicht einer Oberfläche des Verdrahtungselements (83, 84) ausgesetzt ist, einen nicht schwärzungsbehandelten Bereich aufweist, auf dem keine elektrisch leitende schwarze Schicht ausgebildet ist.

7. Solarzellenmodul nach einem der Ansprüche 1 bis 6, wobei die Metallelektrode auf der Rückfläche der Solarzelle und die erste Hauptoberfläche des Verdrahtungselements mit Lot verbunden sind.

## Revendications

1. Module de cellules solaires (200) comprenant :
une chaîne de cellules solaires (100, 110, 120) dans laquelle une pluralité de cellules solaires (102, 103, 104) ont chacune une surface recevant la lumière et une surface arrière, dans laquelle les surfaces arrière de cellules solaires adjacentes sont connectées électriquement par l'intermédiaire d'un élément de câblage (83, 84) ;
un élément de protection de surface recevant la lumière (91) qui transmet la lumière et qui est disposé sur le côté recevant la lumière de la chaîne de cellules solaires (100, 110, 120) ;
un élément de protection de surface arrière (92) disposé sur le côté arrière de la chaîne de cellules solaires ; et
un encapsulant (95) disposé entre l'élément de protection de surface recevant la lumière (91) et l'élément de protection de surface arrière (92) pour encapsuler la chaîne de cellules solaires (100, 110, 120),
dans lequel
les cellules solaires (102, 103, 104) n'ont pas d'électrode métallique sur la surface recevant la lumière, et ont une électrode métallique uniquement sur la surface arrière,
une surface principale d'un côté recevant la lumière de l'élément de protection de surface arrière (92) est noire,
l'élément de câblage (83, 84) est un fil tressé ayant une section transversale de forme plate et est composé d'une pluralité de fils élémentaires métalliques, et une première surface principale de l'élément de câblage (83, 84) est connectée à l'électrode métallique d'une cellule solaire (102, 103, 104), et
**caractérisé en ce que** l'élément de câblage (83, 84) a une couche noire électriquement conductrice sur toute la première surface principale.

2. Module de cellules solaires selon la revendication 1, dans lequel la couche noire électriquement conductrice est une couche métallique contenant du palladium.

3. Module de cellules solaires selon la revendication 1 ou 2, dans lequel le fil élémentaire métallique de l'élément de câblage (83, 84) est constitué de cuivre ou d'alliage de cuivre.

4. Module de cellules solaires selon l'une quelconque des revendications 1 à 3, dans lequel la couche noire électriquement conductrice est une couche de placage autocatalytique formée sur une surface du fil élémentaire métallique.

5. Module de cellules solaires selon l'une quelconque des revendications 1 à 4, dans lequel le coefficient de réflexion de la lumière visible de la première surface principale de l'élément de câblage est de 10 % ou moins.

6. Module de cellules solaires selon l'une quelconque des revendications 1 à 5, dans lequel, dans une partie qui n'est pas exposée à une surface de l'élément de câblage (83, 84), le fil élémentaire métallique qui constitue l'élément de câblage a une région non traitée par noircissement sur laquelle aucune couche noire électriquement conductrice n'est formée.

7. Module de cellules solaires selon l'une quelconque des revendications 1 à 6, dans lequel l'électrode métallique sur la surface d'envers de la cellule solaire et la première surface principale de l'élément de câblage sont connectées par brasage.
